# FASCICULE DE BREVET EUROPEEN

(11) **EP 3 599 684 B1**
(45) Date de publication et mention de la délivrance du brevet: **13.01.2021**
(21) Numéro de dépôt: 19186413.1
(22) Date de dépôt: 16.07.2019
(51) Int. Cl.: H01S 5/02, G02F 1/025, H01S 5/026, H01S 5/042, H01S 5/10, H01S 5/12, H01S 5/125, H01S 5/14

(54) **TRANSMETTEUR PHOTONIQUE**
PHOTONISCHER SENDER
PHOTONIC TRANSMITTER

(30) Priorité: 23.07.2018 FR 1856780
(43) Date de publication de la demande: 29.01.2020
(73) Titulaire: Commissariat à l'Énergie Atomique et aux Énergies Alternatives, 75015 Paris (FR)
(72) Inventeur: HASSAN, Karim, 38054 GRENOBLE Cedex 09 (FR); DESIERES, Yohan, 38054 GRENOBLE Cedex 09 (FR); SZELAG, Bertrand, 38054 GRENOBLE Cedex 09 (FR)
(74) Mandataire: Colombo, Michel

(56) Documents cités:
- EP-A1- 3 206 079
- WO-A1-2014/155450
- WO-A1-2018/029414
- FR-A1- 3 041 116
- HYUNDAI PARK ET AL: "Device and Integration Technology for Silicon Photonic Transmitters", IEEE JOURNAL OF SELECTED TOPICS IN QUANTUM ELECTRONICS, vol. 17, no. 3, 1 mai 2011 (2011-05-01), pages 671-688, XP055157178, ISSN: 1077-260X, DOI: 10.1109/JSTQE.2011.2106112

## Description

L'invention concerne un transmetteur photonique comportant une source laser et un modulateur. L'invention a également pour objet un procédé de fabrication de ce transmetteur.

Des transmetteurs photoniques connus comportent :
- un empilement comportant un substrat s'étendant principalement dans un plan appelé « plan du substrat » et les couches suivantes empilées successivement les unes au-dessus des autres et s'étendant chacune principalement parallèlement au plan du substrat :
   - une première couche située directement sur le substrat et comportant du silicium monocristallin encapsulé dans un matériau diélectrique,
   - une deuxième couche située directement sur la première couche et comportant un matériau diélectrique,
   - une troisième couche située directement sur la deuxième couche et comportant un matériau à gain III-V et un matériau cristallin III-V dopé encapsulés dans un matériau diélectrique,
- une source laser à semi-conducteur apte à générer un signal optique, cette source laser comportant :
   - un premier guide d'onde en silicium structuré dans le silicium monocristallin de la première couche, et
   - un deuxième guide d'onde en matériau à gain III-V structuré dans le matériau à gain III-V de la troisième couche, les premier et deuxième guides d'onde étant couplés optiquement l'un à l'autre par un couplage adiabatique et étant séparés l'un de l'autre à cet effet par une première portion de la deuxième couche,
- un modulateur de phase réalisé sur le même substrat et apte à moduler le signal optique généré par la source laser à semi-conducteur, ce modulateur comportant :
   - une première électrode en silicium monocristallin dopé P ou N dont une première partie est structurée dans le silicium monocristallin de la première couche,
   - une seconde électrode en matériau cristallin III-V dopé structurée dans le matériau cristallin III-V dopé de la troisième couche, cette seconde électrode présentant un dopage de signe opposé à celui de la première électrode et étant séparée de la première électrode par une deuxième portion de la deuxième couche.

Un tel transmetteur est par exemple divulgué dans la demande EP3206079A1.

De l'état de la technique est également connu de :
- WO2018/029414A1,
- Hyundai Park et Al : "Device and Integration Technology for Silicon Photonic Transmetters", IEEE Journal of Selected Topics in Quantum Electronics, Vol. 17, N°3, 1/01/2011,
- FR3041116A1,
- WO2014/155450A1.

L'invention décrite ici vise à proposer un transmetteur présentant les mêmes avantages que celui de la demande EP3206079A1 tout en étant plus simple à fabriquer.

Elle a donc pour objet un tel transmetteur conforme à la revendication 1.

Les modes de réalisation de ce transmetteur peuvent comporter une ou plusieurs des caractéristiques des revendications dépendantes.

L'invention a également pour objet un procédé de fabrication du transmetteur photonique à semi-conducteur objet de la présente demande.

Les modes de réalisation de ce procédé de fabrication peuvent comporter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :
- la figure 1 est une illustration schématique d'un transmetteur en coupe verticale ;
- la figure 2 est une illustration schématique partielle, en coupe verticale, de détails du transmetteur de la figure 1 ;
- la figure 3 est un organigramme d'un premier procédé de fabrication du transmetteur de la figure 1 ;
- les figures 4 à 11 sont des illustrations schématiques, en coupe verticale, de différents états de fabrication obtenus lors de la mise en œuvre du procédé de la figure 3 ;
- la figure 12 est un organigramme partiel d'un deuxième procédé de fabrication du transmetteur de la figure 1 ;
- la figure 13 est une illustration schématique, en coupe verticale, d'un état de fabrication obtenu lors de la mise en œuvre du procédé de la figure 12 ;
- la figure 14 est un organigramme d'un troisième procédé de fabrication du transmetteur de la figure 1 ;
- les figures 15 à 17 sont des illustrations schématiques, en coupe verticale, de différents états de fabrication obtenus lors de la mise en œuvre du procédé de la figure 14.

Dans ces figures, les mêmes références sont utilisées pour désigner les mêmes éléments. Dans la suite de cette description, les caractéristiques et fonctions bien connues de l'homme du métier ne sont pas décrites en détail.

### Chapitre I : Exemples de modes de réalisation

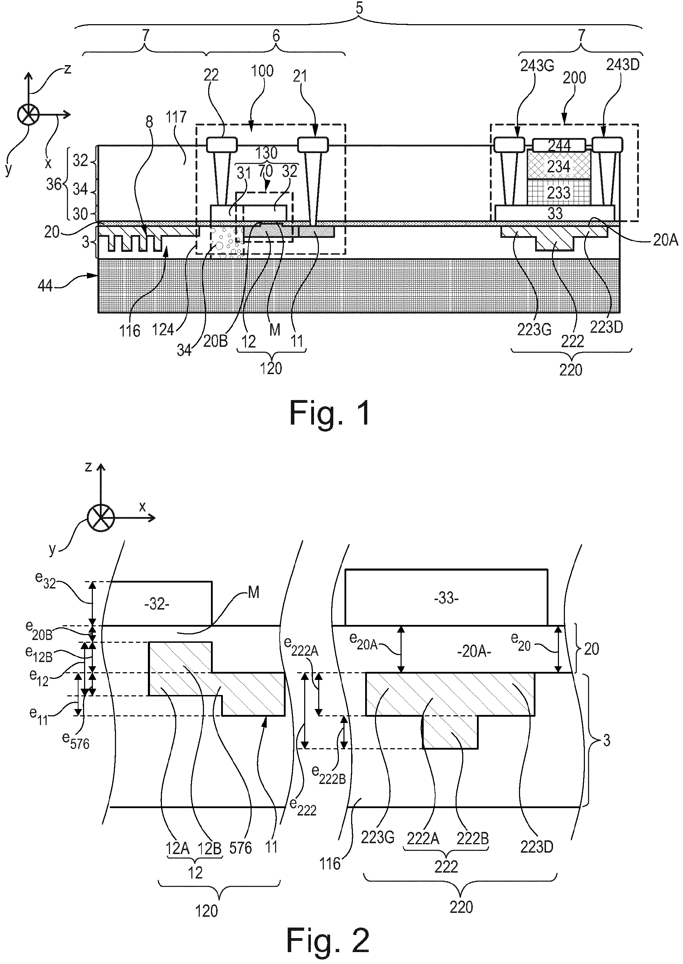

La figure 1 représente un transmetteur 5 d'un signal optique modulé en phase et/ou en amplitude pour transmettre des bits d'informations vers un récepteur par l'intermédiaire d'une fibre optique par exemple. A cet effet, le transmetteur 5 comporte une source laser 7 qui émet un signal optique dont la phase et/ou l'amplitude est ensuite modulée par un système 6 de modulation de phase et/ou d'amplitude de ce signal optique.

Par exemple, la longueur d'onde λ_{Li} du signal optique émis par la source laser 7 est comprise entre 1240 nm et 1630 nm.

Le système 6 peut être un système de modulation de la phase seule, ou de l'amplitude seule ou simultanément de la phase et de l'amplitude.

Typiquement, la source laser 7 est un laser DBR (« distributed bragg reflector laser ») ou DFB (« distributed feedback laser »). Une telle source laser est bien connue et seuls les détails nécessaires pour la compréhension de l'invention sont décrits ici. Par exemple, pour des détails généraux et le fonctionnement d'une telle source laser, le lecteur peut se référer aux articles suivants :
- B. Ben Bakir et al., « Hybrid Si/III-V lasers with adiabatic coupling », 2011.
- B. Ben Bakir, C. Sciancalepore, A. Descos, H. Duprez, D. Bordel, L. Sanchez, C. Jany, K. Hassan, P. Brianceau, V. Carron, and S. Menezo, « Heterogeneously Integrated III-V on Silicon Lasers », Invited Talk ECS 2014.

Pour simplifier la figure 1 et les figures suivantes, seul un guide d'onde laser hybride 200, 220 et un coupleur surfacique 8 (connu sous le terme anglais de « Surface grating coupler ») de la source laser 7 sont représentés.

Un tel coupleur 8 est par exemple décrit dans l'article suivant : F. Van Laere, G. Roelkens, J. Schrauwen, D. Taillaert, P. Dumon, W. Bogaerts, D. Van Thourhout and R. Baets, « Compact grating couplers between optical fibers and Silicon-on-Insulator photonic wire waveguides with 69% coupling efficiency*".* Il est réalisé dans une couche 3 comportant du silicium monocristallin encapsulé dans un matériau diélectrique 116. Généralement, un matériau diélectrique a une conductivité électrique à 20 °C inférieure à 10⁻⁷ S/m et, de préférence, inférieure à 10⁻⁹S/m ou 10⁻¹⁵S/m. De plus, dans le cas du matériau diélectrique 116, son indice de réfraction est strictement inférieur à l'indice de réfraction du silicium. Par exemple, dans ce mode de réalisation, le matériau diélectrique 116 est du dioxyde de silicium (SiO₂).

La couche 3 s'étend principalement dans un plan horizontal. La couche 3 est directement située sur un substrat rigide 44. Dans la couche 3, le silicium monocristallin est situé dans un même plan horizontal parallèle au plan du substrat 44. Ici, le silicium monocristallin de la couche 3 est également isolé mécaniquement et électriquement du substrat 44 par le matériau diélectrique 116. Par exemple, l'épaisseur de silicium monocristallin dans la couche 3 est comprise entre 100 nm et 800 nm. Dans cet exemple, l'épaisseur du silicium monocristallin dans la couche 3 est égale à 65 nm ou 150nm ou 300 nm ou 500 nm.

Sur la figure 1 et les figures suivantes, l'horizontal est représenté par des directions X et Y d'un repère orthogonal. La direction Z de ce repère orthogonal représente la direction verticale. Par la suite, les termes tels que « supérieur », « inférieur », « au-dessus », « en dessous », « haut » et « bas » sont définis par rapport à cette direction Z. Les termes « gauche » et « droite » sont définis par rapport à la direction X. Les termes « avant » et « arrière » sont définis par rapport à la direction Y.

La figure 1 représente les éléments du transmetteur 5 en coupe dans un plan vertical parallèle aux directions X et Z.

Le guide d'onde laser hybride 200, 220 est constitué d'un guide d'onde 200 réalisé dans un matériau a gain III-V et d'un guide d'onde 220 en silicium monocristallin. Généralement le guide d'onde 200 est utilisé pour générer et amplifier un signal optique à l'intérieur d'une cavité optique de la source laser 7. Ici, à cet effet, il est réalisé dans une couche 36 comportant un matériau à gain III-V encapsulé dans un matériau diélectrique 117. Par exemple, le matériau 117 est du dioxyde de silicium ou du nitrure de silicium. Cette couche 36 s'étend horizontalement directement sur une couche 20 en matériau diélectrique. La couche 20 s'étend elle-même horizontalement directement sur la couche 3, du côté de cette couche 3 opposé au substrat 44.

Le substrat 44 s'étend horizontalement dans un plan appelé « plan du substrat ». Dans cet exemple de réalisation, le substrat 44 est un support dont l'épaisseur est typiquement supérieure à 200 µm ou 400 µm. Par exemple, substrat 4 est un support en silicium.

L'épaisseur e₂₀ de la couche 20 est typiquement comprise entre 40 nm et 1 µm ou 500 nm et, de préférence, entre 50 nm et 150 nm ou entre 50 nm et 140 nm. A titre d'illustration, ici, l'épaisseur e₂₀ est égale à 85 nm ou 100 nm.

La couche 36 comprend typiquement une sous-couche inférieure dopée 30, un empilement 34 de puits quantiques ou boites quantiques en quaternaire et une sous-couche supérieure 32 dopée avec un dopant de signe opposé à celui de la sous-couche 30. Les sous-couches 30 et 32 sont par exemple ici en alliage InP monocristallin dopé N ou P. Dans ce cas, l'empilement 34 est, par exemple, un empilement en alternance de sous-couches en InGaAsP ou en AlGaInAs ou autre.

Sur la figure 1, seule une bande 33, un empilement 233 et une bande 234 réalisés, respectivement, dans la sous-couche 30, l'empilement 34 et la sous-couche 32 sont représentés. Cette superposition de la bande 33, de l'empilement 233 et de la bande 234 constitue le guide d'onde 200.

Le guide d'onde 200 comporte également :
- des prises 243G et 243D de contact en contact mécanique et électrique directement avec la bande 33 et situées, respectivement, à gauche et à droite de l'empilement 233, et
- une prise 244 de contact en contact mécanique et électrique directement avec la bande 234.

Ces prises 243G, 243D et 244 permettent d'injecter un courant électrique dans le guide d'onde 200 en matériau à gain III-V entre les prises 243G, 243D et la prise 244.

Le guide d'onde 220 est en silicium et structuré dans le silicium monocristallin de la couche 3. Ce guide d'onde 220 s'étend sous la bande 33. Dans la figure 1, le guide d'onde 220 est représenté, à titre d'illustration, dans le cas particulier où la direction de propagation du signal optique à l'intérieur de ce guide d'onde est parallèle à la direction Y. Ici, le guide d'onde 220 est un guide d'onde à arrête connu sous le terme anglais de « RIB waveguide». Ainsi, la section transversale de ce guide d'onde, parallèlement au plan XZ, présente un renflement central 222 à partir duquel s'étendent de chaque côté, parallèlement à la direction X, des bras latéraux 223G et 223D plus fins. Ici, le guide d'onde 220 est uniquement séparé de la bande 33 par une portion 20A de la couche 20.

Le guide d'onde 220 est raccordé optiquement au guide d'onde 200 par un couplage adiabatique. Pour une description détaillée d'un couplage adiabatique le lecteur peut se référer à l'article suivant : Amnon Yariv et al., « Supermode Si/III-V hybrid Lasers, optical amplifiers and modulators: proposai and analysis » Optics Express 9147, vol. 14, No. 15, 23/07/2007.

Les caractéristiques du couplage optique entre le guide d'onde 220 et le guide d'onde 200 dépendent notamment :
- des dimensions du guide d'onde 220 et, en particulier, de l'épaisseur e₂₂₂ du renflement central 222, et
- de l'épaisseur e_{20A} de matériau diélectrique dans la portion 20A de la couche 20 interposée entre les guides d'onde 200 et 220.

Il est donc important que les épaisseurs e₂₂₂ et e_{20A} puissent être ajustées indépendamment des dimensions des autres composants photoniques réalisés sur le même substrat 44. Ici, pour optimiser le fonctionnement de la source laser 7, l'épaisseur e_{20A} est supérieure à 40 nm et, typiquement, comprise entre 40 nm et 1 µm ou entre 40 nm et 500 nm. Ici, l'épaisseur e_{20A} est égale à l'épaisseur e₂₀ de la couche 20. Avec un tel choix de l'épaisseur e_{20A}, le couplage entre les guides d'onde 200 et 220 est adiabatique. Dans ces conditions, de préférence, seul le guide d'onde 220 présente des extrémités en forme de pointe pour assurer un bon échange de puissance optique entre les guides d'onde 200 et 220. Ces formes de pointe sont connues sous le terme anglais de « tapers ».

Toujours pour optimiser le fonctionnement de la source laser 7, l'épaisseur e₂₂₂ est supérieure ou égale à 220 nm ou 300 nm. Par exemple, ici, l'épaisseur e₂₂₂ est égale à 500 nm.

Pour moduler la phase ou l'amplitude du signal optique, le système 6 comporte au moins un modulateur de phase et, souvent, au moins un dispositif d'accord de phase. Par exemple, le système 6 est un interféromètre de Mach-Zehnder dans lequel le modulateur et le dispositif d'accord de phase sont agencés dans l'une des branches de cet interféromètre pour moduler l'amplitude et/ou la phase du signal optique généré par la source laser 7. Les structures d'un interféromètre de Mach-Zehnder et d'un dispositif d'accord de phase sont bien connues et ne sont pas décrites ici en détail. Le dispositif d'accord de phase est par exemple le même que celui décrit dans la demande EP3206079. Par conséquent, pour simplifier la figure 1, seul un modulateur 100 de phase est représenté.

Le modulateur 100 permet de modifier rapidement la phase du signal optique. A cet effet, le modulateur 100 est ici un modulateur électro-optique connu sous l'acronyme EOM (« Electro-Optic Modulator ») et, plus précisément, un modulateur capacitif hybride. Il comporte donc deux électrodes 120 et 130 situées en vis-à-vis l'une de l'autre et formant un condensateur.

L'électrode 120 est en silicium monocristallin dopé. Elle est structurée au moins en partie dans le silicium monocristallin de la couche 3. Elle s'étend, dans la direction X, depuis une extrémité proximale 12 jusqu'à une extrémité distale 11. Elle s'étend également dans la direction Y.

Ici, l'extrémité distale 11 est plus dopée que l'extrémité proximale 12. Par exemple, la concentration de dopant dans l'extrémité distale 11 est comprise entre 10¹⁹ et 10²¹ atomes/cm³. La concentration de dopant dans l'extrémité proximale 12 est par exemple comprise entre 10¹⁷ et 10¹⁹ atomes/cm³.

L'électrode 130 est réalisée en matériau cristallin III-V dopé avec un dopage de signe opposé à celui de l'électrode 120. Ici, elle est réalisée en InP. La concentration en dopant de l'électrode 130 est comprise, par exemple, entre 10¹⁷ et 2 x 10¹⁸ atomes/cm³ ou entre 10¹⁷ et 2 x 10¹⁹ atomes/cm³.

L'électrode 130 s'étend, parallèlement à la direction X, depuis une extrémité proximale 32 jusqu'à une extrémité distale 31. L'électrode 130 s'étend également dans la direction Y. Elle est directement située sur la couche 20.

L'extrémité proximale 32 est située en vis-à-vis de l'extrémité proximale 12 et séparée de cette extrémité proximale 12 uniquement par une portion 20B de la couche 20 interposée entre ces extrémités proximales. Par rapport à un plan vertical parallèle aux directions Y et Z et passant par les extrémités proximales 12 et 32, l'extrémité distale 31 est située d'un côté de ce plan tandis que l'extrémité distale 11 est située de l'autre côté. Les extrémités distales 11 et 31 ne sont donc pas en vis-à-vis.

La zone 34, qui s'étend verticalement depuis l'extrémité distale 31 jusqu'au substrat 44, comporte uniquement des matériaux diélectriques solides. Ici, il s'agit du matériau diélectrique 116 et du matériau diélectrique de la couche 20. Grâce à cela, la capacité parasite entre cette extrémité 31 et le substrat 44 est fortement réduite. Cette zone 34 est, par exemple, identique à celle décrite dans la demande EP3206079.

La superposition, dans la direction Z, de l'extrémité proximale 12, de la portion 20B de la couche 20 et de l'extrémité proximale 32 est dimensionnée pour former un guide d'onde 70, capable de guider, dans la direction Y, le signal optique généré par la source laser 7. Les guides d'onde 70 est typiquement raccordé optiquement à la source laser 7 par l'intermédiaire d'autres guides d'onde et d'autres coupleurs structurés dans la couche 3. Pour simplifier la figure 1, ces autres guides d'onde et autres coupleurs n'ont pas été représentés.

Le modulateur 100 comporte aussi deux prises de contact 21 et 22, en contact mécanique et électrique directement avec, respectivement, les extrémités distales 11 et 31. Ces prises 21 et 22 sont raccordées à une source de tension pilotable en fonction du bit ou des bits d'information à transmettre par le transmetteur 5.

La figure 2 représente plus en détail la structure de l'électrode 120 et du guide d'onde 220. Sur cette figure, les lignes ondulées indiquent que des parties du transducteur 5 n'ont pas été représentées. De plus, pour simplifier la figure, les prises de contact 21, 22, 243G et 243D ne sont pas représentées.

Le renflement central 222 du guide d'onde 220 comporte une partie centrale 222A sur la face inférieure de laquelle est directement déposée une surépaisseur 222B de silicium monocristallin pour atteindre l'épaisseur e₂₂₂ souhaitée. La limite entre la partie centrale 222A et la surépaisseur 222B est représentée sur la figure 2 par une ligne horizontale en pointillés. Dans ce mode de réalisation, la surépaisseur 222B est aussi réalisée en silicium monocristallin.

Par exemple, ici, l'épaisseur e_{222A} de la partie centrale 222A est égale à 300 nm et l'épaisseur e_{222B} de la surépaisseur 222B est égale à 200 nm. Ainsi, l'épaisseur e222 du renflement 222 est égale à 500 nm. Dans ce mode de réalisation, l'épaisseur e₂₂₃ des bras latéraux 223D et 223G est égale à l'épaisseur e_{222A}, c'est-à-dire à 300 nm.

L'extrémité distale 11 s'étend continûment depuis l'interface entre les couches 3 et 20 jusqu'à une face inférieure enfouie à l'intérieur de la couche 3. L'épaisseur de l'extrémité distale 11 est notée eu. Ici, l'épaisseur e₁₁ est égale à 300 nm. Dans ce mode de réalisation, les extrémité proximale 12 et distale 11 sont mécaniquement et électriquement raccordées l'une à l'autre par une partie intermédiaire 576 dont l'épaisseur e₅₇₆ est strictement inférieure à l'épaisseur eu et à l'épaisseur e₁₂ de l'extrémité proximale 12. L'épaisseur e₅₇₆ est choisie de manière à empêcher ou à limiter la propagation du signal optique dans l'extrémité distale 11. Par exemple, l'épaisseur e₅₇₆ est inférieure ou égale à e₁₂/2. Ici, l'écart entre les épaisseurs e₅₇₆ et e₁₁ est typiquement supérieure à 50 nm ou 100 nm. De façon similaire l'écart entre les épaisseurs e₅₇₆ et e₁₂ est typiquement supérieure à 50 nm ou 100 nm. Pour limiter le nombre de niveaux de gravure l'épaisseur e₁₁ est égale à l'épaisseurs e_{222A}. Ici, l'épaisseur e₅₇₆ est égale à 65 nm. Cette conformation de l'électrode 120 permet aussi un meilleur contrôle de la capacité du modulateur.

L'extrémité proximale 12 est réalisée en deux parties :
- une première partie 12A structurée uniquement dans le silicium monocristallin de la couche 3, et
- une deuxième partie 12B en silicium monocristallin réalisée à l'intérieure de la portion 20B de la couche 20 et située directement sur la partie 12A.
Sur la figure 2, la limite entre les parties 12A et 12B est représentée par une ligne horizontale en pointillés. L'épaisseur de la partie 12B est notée e_{12B}. Cette épaisseur est mesurée à partir de l'interface entre les couches 3 et 20 et jusqu'à la face supérieure de la partie 12B enfouie à l'intérieur de la couche 20.

A l'intérieur de la portion 20B, à cause de la présence de la partie 12B, l'épaisseur e_{20B} du matériau diélectrique de la couche 20 qui isole mécaniquement et électriquement les extrémités proximales 12 et 32 est réduite. Ici, l'épaisseur e_{12B} est choisie de manière à ce que l'épaisseur restante e_{20B} de matériau diélectrique soit assez fine pour obtenir un bon couplage capacitif entre les électrodes 120 et 130. A cet effet, l'épaisseur e_{20B} est comprise entre 5 nm et 35 nm. Par exemple, l'épaisseur e_{20B} est ici égale à 10 nm. L'épaisseur e_{12B} de la partie 12B est reliée aux épaisseurs e_{20B} et e₂₀ par la relation suivante : e_{12B} = e₂₀ - e_{20B}.

Ici, pour limiter le nombre de niveaux de gravure du silicium monocristallin de la couche 3, l'épaisseur de la partie 12A est choisie égale à l'épaisseur e₅₇₆.

Dans ce mode de réalisation, l'épaisseur e₃₂ de l'extrémité proximale 32 de l'électrode 130 est choisie pour optimiser le ratio déphasage optique sur perte optique. Pour cela, par exemple, différentes valeurs de l'épaisseur e₃₂ sont simulées expérimentalement pour déterminer laquelle de ces valeurs permet d'optimiser ce ratio. Par exemple, dans le cas présent où les épaisseurs e₁₂ et e_{20B} sont égales, respectivement, à 140 nm et 10 nm, il a été déterminé expérimentalement que l'épaisseur e₃₂ qui optimise ce ratio est comprise entre 80 nm et 100 nm. Ici, l'épaisseur e₃₂ est choisie égale à 90 nm.

Un fonctionnement possible du transmetteur 5 est le suivant. La source laser 7 génère un signal optique. Au moins, une partie de ce signal optique est dirigée vers un interféromètre de Mach Zehnder dont au moins l'une des branches comporte le modulateur 100. Cette partie de signal optique est donc guidée par le guide d'onde 70 avant d'être recombinée avec une autre partie du signal optique guidée par l'autre branche de l'interféromètre de Mach Zehnder pour former le signal optique modulé.

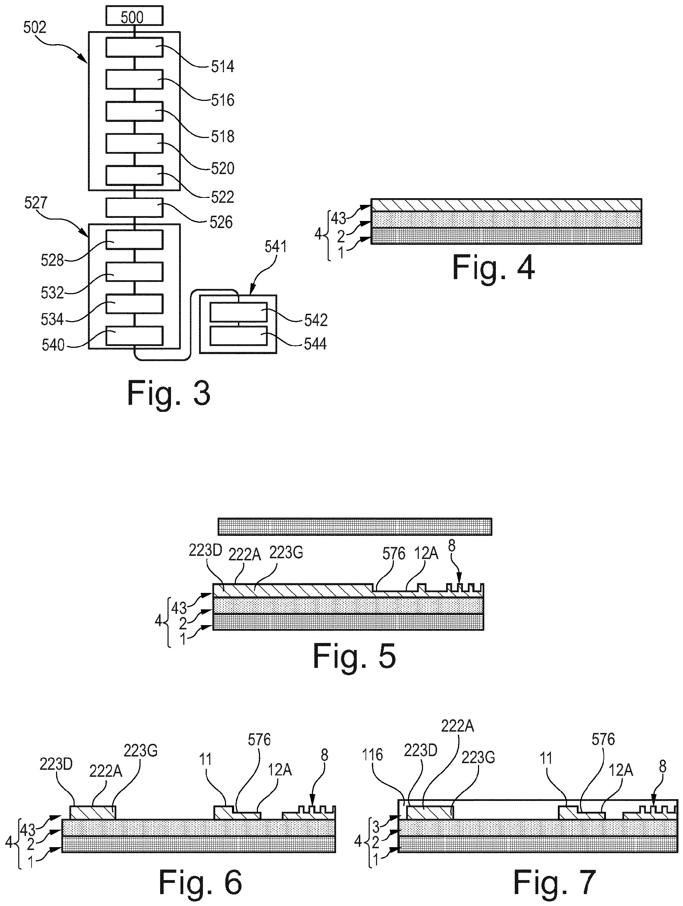

Un procédé de fabrication du transmetteur 5 va maintenant être décrit en référence aux figures 3 à 11. Les figures 4 à 11 représentent différents états de fabrication du transmetteur 5 en coupe verticale parallèlement aux directions X et Z. Pour simplifier ces figures et la description de ce procédé, les étapes et opérations classiques de fabrication des autres composants optiques que ceux représentés sur la figure 1 et nécessaires au fonctionnement du transmetteur 5, est omise.

Lors d'une étape 500, le procédé débute par la fourniture d'un substrat 4 (Figure 4). Ici, ce substrat 4 est un substrat SOI (« silicon on insulator »). Le substrat 4 comporte directement empilés les uns au-dessus des autres dans la direction Z :
- un support 1 en silicium, d'épaisseur supérieur à 400 µm ou 700 µm classiquement,
- une couche 2 enterrée en dioxyde de silicium, et
- une couche 43 en silicium monocristallin qui, à ce stade, n'a pas encore été gravée ni encapsulée dans un matériau diélectrique.

L'épaisseur de la couche 2 est supérieure ou égale à l'épaisseur e_{12B}. Ici, l'épaisseur de la couche 2 est donc supérieure 75 nm ou 90 nm. Par exemple, l'épaisseur de la couche 2 est supérieure à 500 nm ou 1 µm et, généralement, inférieure à 10 µm ou 20 µm. Dans cet exemple de réalisation, l'épaisseur de la couche 2 est égale à 800 nm.

L'épaisseur de la couche 43 est ici égale à l'épaisseur e₁₁ ou e_{222A}. Elle est donc égale à 300 nm. Dans ce mode de réalisation, l'épaisseur de la couche 43 est par contre inférieure à l'épaisseur e₂₂₂ souhaitée.

Lors d'une étape 502, la couche 3 est réalisée. Pour cela, la couche 43 est gravée pour structurer les différentes parties des composants optiques situées à l'intérieur de la couche 3 et dont les épaisseurs sont inférieures ou égales à l'épaisseur de la couche 43. Ainsi, lors de cette étape 502, les bras 223D, 223G, la partie centrale 222A, l'extrémité distale 11, la partie intermédiaire 576, la partie 12A de l'extrémité proximale 12 et le coupleur surfacique 8 sont structurés dans la couche 43 de silicium monocristallin.

Par exemple, lors d'une opération 514, la couche 43 subit une première gravure localisée partielle (figure 5) pour amincir l'épaisseur du silicium aux emplacements requis pour la réalisation du coupleur surfacique 8, de la partie intermédiaire 576 et de la partie 12A de l'extrémité proximale 12. A l'issue de l'opération 514, les régions amincies présentent une épaisseur égale à l'épaisseur e₅₇₆.

A l'inverse, lors de cette opération 514, d'autres régions dite « non-amincies », ne sont pas gravées et conservent leur épaisseur initiale. En particulier, ces régions non-amincies sont situées à l'emplacement de la partie centrale 222A du renflement 222, des bras 223D et 223G et à l'emplacement de l'extrémité distale 11.

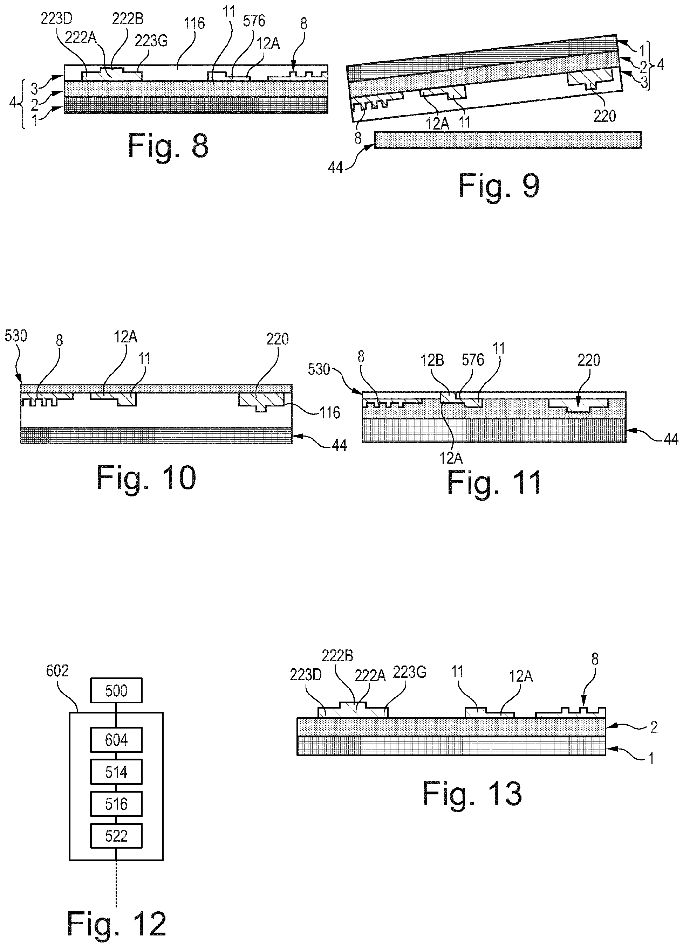

Lors d'une opération 516, une gravure totale localisée de la couche 43 est réalisée (figure 8). Contrairement à la gravure partielle, la gravure totale élimine complètement l'épaisseur de silicium de la couche 43 dans les régions non masquées où elle est appliquée. A l'inverse, des régions masquées protègent la couche 43 de cette gravure totale. Cette gravure totale est réalisée de manière à structurer, simultanément dans la couche 43, les bras 223D, 223G, la partie centrale 222A, l'extrémité distale 11, la partie intermédiaire 576 et la partie 12A de l'extrémité proximale 12 et le coupleur surfacique 8. A cet effet, seules les régions correspondant à ces différents éléments sont masquées. On obtient à l'issue de cette étape, l'état représenté sur la figure 6.

Lors d'une opération 518, la couche 43 de silicium monocristallin, qui a été structurée lors des étapes précédentes, est encapsulée dans le matériau diélectrique 116 (figure 7). A l'issue de l'opération 518, l'épaisseur de la couche 3 est égale à l'épaisseur e₂₂₂, c'est-à-dire ici égale à 500 nm.

Ensuite, lors d'une opération 520, la surépaisseur 222B est formée sur la partie centrale 222A déjà structurée lors des opérations précédentes. Ici la surépaisseur 222B est formée en mettant en œuvre un procédé connu sous le nom de « Damascène ». Ce procédé est par exemple décrit en référence à la figure 3 de l'article suivant : P. Dong et al. : « Novel intégration technique for silicon/III-V hybrid laser », Optics Express 22(22), Vol. 22, N°22, pp. 26861, 2014. En résumé, il consiste à creuser dans le matériau 116 une tranchée dont le fond débouche sur la partie centrale 222A puis à déposer ou à faire croître par épitaxie du silicium monocritallin à l'intérieur de cette cavité. Enfin, une opération de polissage permet de retirer l'excédent de silicium monocristallin qui a été déposé ou qui a cru au-dessus et/ou sur les côtés de la tranchée.

Pour achever la réalisation de la couche 3, lors d'une opération 522, une nouvelle opération d'encapsulation est mise en œuvre pour encapsuler la surépaisseur 222B à l'intérieur du matériau 116.

La face supérieure du matériau 116 est ensuite préparée pour un collage, par exemple direct ou moléculaire, c'est-à-dire sans apport de matière. Par exemple, la face supérieure du matériau 116 est polie à l'aide d'un procédé tel qu'un procédé de CMP (Chemical-Mechanical Polishing).

Lors d'une étape 526, la face supérieure du substrat 4, c'est-à-dire à ce stade la face polie du matériau 116, est ensuite collée sur la face extérieure du substrat 44 (figure 9), par exemple, par collage moléculaire. Le substrat 44 a déjà été décrit en référence à la figure 1.

Ensuite, lors d'une étape 527, la couche 20 est fabriquée sur la couche 3. Pour cela, lors d'une opération 528, le support 1 est retiré, et la couche 2 est partiellement amincie pour ne laisser subsister qu'une fine sous-couche 530 (Figure 10) de dioxyde de silicium sur la couche 3. L'épaisseur de sous-couche 530 est égale à l'épaisseur e_{12B}. Ici, son épaisseur est donc égale à 75 nm ou 90 nm.

Lors d'une opération 532, la partie 12B de l'extrémité distale 12 est formée sur la partie 12A. Par exemple, la partie 12B est réalisée en mettant en œuvre un procédé Damascène comme lors de l'opération 520. Dans ce cas, la tranchée est creusée dans la sous-couche 530 et débouche sur la face supérieure de la partie 12A déjà réalisée. L'épaisseur de la partie 12B ainsi formée est égale à l'épaisseur de la sous-couche 530 et donc égale à 75 nm ou 90 nm. On obtient alors l'état représenté sur la figure 11.

Lors d'une opération 534, des opérations de dopage localisé sont mises en œuvre pour obtenir les différents niveaux de dopage souhaités pour les extrémités proximale 11 et distale 12 de l'électrode 120. Ces opérations de dopage localisé étant classiques, celles-ci ne sont pas décrites ici. De préférence, le dopage de l'électrode 120 est un dopage P. Ici, il est obtenu par implantation ionique en Bore.

Lors d'une opération 540, la partie 12B est encapsulée dans une deuxième sous-couche de matériau diélectrique pour finaliser la réalisation de la couche 20.. Par exemple, ce matériau diélectrique est du dioxyde de silicium. Ainsi, à l'issue de cette opération, la partie 12B est recouverte d'une épaisseur e_{20B} de dioxyde de silicium et l'épaisseur de la portion 20A de la couche 20 présente maintenant une épaisseur égale à l'épaisseur e_{20A} souhaitée. Lors de cette opération 540, la face supérieure de la couche 20 est aussi préparée pour un collage, par exemple direct ou moléculaire. Ainsi, typiquement, la face supérieure de la couche 20 est polie à l'aide d'un procédé tel qu'un procédé de CMP (Chemical-Mechanical Polishing).

Enfin, lors d'une étape 541, la couche 36 est fabriquée.

Lors d'une opération 542, l'électrode 130 et le guide d'onde 200 sont réalisés sur la face supérieure de la couche 20. Ici, l'électrode 130 et le guide d'onde 120 sont réalisés par collage direct de deux empilements distincts en matériau III-V, un pour la réalisation de l'électrode 130 et un autre pour la réalisation du guide d'onde 200. L'utilisation de deux empilements distincts en matériau III-V permet de choisir l'épaisseur de l'électrode 130 indépendamment de l'épaisseur de la bande 33. La réalisation de l'électrode 130 et du guide d'onde 200 par collage et structuration d'empilements de matériau III-V est classique et n'est pas décrit ici plus en détail. Par exemple, le lecteur intéressé peut consulter les articles suivants pour des exemples de telles réalisations :
- H. Duprez et al. : "1310 nm hybrid InP/InGaAsP on silicon distributed feedback laser with high side-mode suppression ratio", Optic Express 23(7), pp. 8489-8497 (2015),
- J.-H. Han et al. : "Efficient low-loss InGaAsP/Si hybrid MOS optical modulator," Nature Photonics 11, pp. 486 (2017).

Lors d'une opération 544, l'électrode 130 et le guide d'onde 200 sont encapsulés dans le matériau diélectrique 117. On obtient alors la couche 36 comportant le matériau à gain III-V et le matériau III-V dopé encapsulés dans le matériau diélectrique 117. Enfin, les prises de contact 21, 22, 243G et 243D sont réalisées. On obtient alors le transmetteur 5 tel que représenté sur la figure 1.

La figure 12 représente un organigramme d'un deuxième procédé de fabrication possible du transmetteur 5. Le procédé de la figure 12 est identique au procédé de la figure 3 sauf que :
- l'épaisseur initiale de la couche 43 en silicium monocristallin du substrat 4 fourni lors de l'étape 500 est égale à 500 nm et non plus à 300 nm et
- l'étape 502 de réalisation de la couche 3 est remplacée par une étape 602.

L'étape 602 est identique à l'étape 502 sauf qu'une opération 604 supplémentaire de gravure localisée est introduite avant l'opération 514 de gravure localisée. Lors de l'opération 604, la couche 43 subit une première gravure localisée partielle pour amincir l'épaisseur du silicium de partout sauf à l'emplacement de la surépaisseur 222B. A l'issue de l'opération 604, l'épaisseur de la couche 43 est égale à 300 nm sauf à l'emplacement de la surépaisseur 222B où son épaisseur est égale à 500 nm. Ensuite, les opérations 514 et 516 sont réalisées en prenant soin de ne pas amincir l'épaisseur de la couche 43 à l'emplacement de la surépaisseur 222B. Ainsi, à l'issue des opérations 604, 514 et 518, l'état représenté sur la figure 13 est obtenu. Dans ce mode de réalisation, la surépaisseur 222B est réalisée par gravure de la couche 43. Ainsi, les opérations 518 et 520 sont omises.

Ensuite, les étapes de ce procédé sont identiques à celles déjà décrites en référence à la figure 3. Pour simplifier la figure 12, leur représentation est omise et remplacée par une ligne en pointillés.

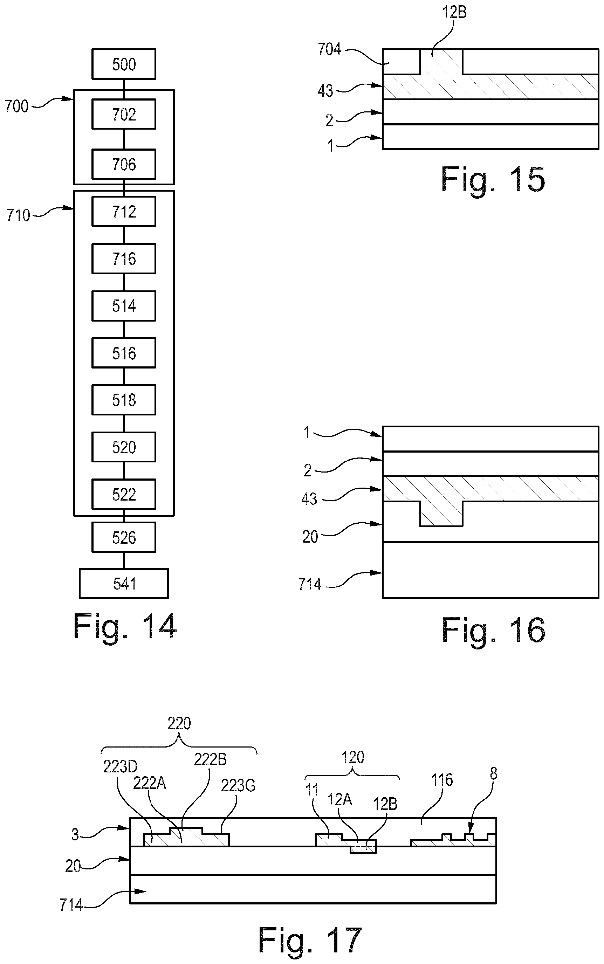

La figure 14 représente un troisième procédé de fabrication possible du transmetteur 5. Ce procédé commence par la réalisation de la couche 20 avant la réalisation des couches 3 et 36. Dans ce procédé, les étapes et opérations déjà décrites en référence à la figure 3 ne sont pas à nouveau décrites.

Après l'étape 500, ce procédé comporte une étape 700 de réalisation de la couche 20. Par exemple, l'étape 700 débute par une opération 702 de réalisation de la partie 12B de l'électrode. Ici, cette opération 702 est identique à l'opération 532. Pour cela, au préalable, lors de l'étape 700 une couche d'oxyde 704 (Figure 15) dont l'épaisseur est égale à l'épaisseur e_{12B} est réalisée sur la face supérieur du substrat 4. A la fin de l'opération 702, l'état représenté sur la figure 15 est obtenu.

Ensuite, lors d'une opération 706, la partie 12B réalisée est encapsulée dans du dioxyde de silicium. Par exemple, cette étape est identique à l'opération 540 du procédé de la figure 3. Ainsi, à la fin de l'étape 700, on obtient la couche 20 immédiatement au-dessus de la couche 43.

Ensuite, lors d'une étape 710, la couche 3 est réalisée. Pour cela, lors d'une opération 712, la face supérieure de la couche 20 est collée, par exemple par collage direct, sur un substrat 714 en silicium amorphe. On obtient alors l'état représenté sur la figure 16.

Lors d'une opération 716, le support 1 et la couche 2 sont retirés pour mettre à nu la couche 43 en silicium monocristallin.

Ensuite, les opérations suivantes sont réalisées :
- l'opération 514 de gravure localisée, puis
- l'opération 516 de gravure totale localisée, puis
- l'opération 518 d'encapsulation, puis
- l'opération 520 de formation de la surépaisseur 222B, puis
- l'opération 522 d'encapsulation de la surépaisseur 222B formée.

A l'issue de l'étape 710, l'état représenté sur la figure 17 est obtenu.

La face supérieure du matériau 116 est ensuite préparée pour un collage, par exemple direct.

L'étape 526 de collage de la face supérieure de la couche 36 sur la face supérieure du substrat 4 est alors exécutée.

Lors d'une étape 720, le substrat 714 est alors retiré pour mettre à nue la face de la couche 20.

Enfin, l'étape 541 de fabrication de la couche 36 sur la couche 20 est exécutée.

### Chapitre II : Variantes

### Variantes de l'électrode 120 :

La partie intermédiaire 576 peut être séparée de la couche 20 par un renfoncement remplit d'un matériau diélectrique. Typiquement, le renfoncement est rempli du matériau 116. Le fond de ce renfoncement est essentiellement horizontal et espacé de la couche 20 par une profondeur p₅₇₈. La profondeur p₅₇₈ est typiquement supérieure à 50 nm ou 100 nm. Ici, la profondeur p₅₇₈ est égale à 65 nm. Cette conformation de la partie intermédiaire permet un meilleur contrôle de la largeur du guide d'onde 70. Une telle conformation de la partie intermédiaire 576 et sa fabrication sont décrits dans la demande EP3206079. Elle n'est donc pas décrite ici plus en détail.

La partie intermédiaire 576 peut aussi être omise.

Dans une variante, le dopage de l'extrémité proximale 12 et de l'extrémité distale 11 sont les mêmes. Dès lors, lors de la fabrication de l'électrode 120, une seule étape de dopage de la couche 43 en silicium monocristallin est nécessaire.

L'électrode 120 peut aussi présenter un dopage N. Un tel dopage N est par exemple obtenu par implantation d'ion Phosphore. Dans ce cas, l'électrode 130 présente un dopage P.

Les parties 12A et 12B de l'extrémité distale 12 ne sont pas nécessairement réalisées dans le même matériau semi-conducteur. Par exemple, la partie 12B peut être réalisée en alliage SiGe ou par une superposition de couche en silicium et en alliage SiGe. La partie 12B peut aussi être réalisée en silicium amorphe. Par exemple, cette surépaisseur de silicium amorphe est déposée sur le silicium monocristallin en mettant en œuvre l'un des procédés décrits dans les articles suivants :
- T. Ferrotti et al., ''O-band III-V-on-amorphous-silicon lasers integrated with a surface grating coupler," IEEE Phot. Technol. Lett. 28(18) pp.1944, 2016
- B. Szelag et al.," Hybrid III-V/Si DFB laser intégration on a 200 mm fully CMOS-compatible silicon photonics platform", in Proc. of Electron Devices Meeting (IEDM), 2017 IEEE International, pp. 24.1, 2017

### Variantes de l'électrode 130 :

Le matériau III-V utilisé pour réaliser l'électrode 130 peut être différent. Par exemple, il peut s'agir de l'alliage InP, de l'alliage AsGa, de l'alliage InGaAsP, ou AlGaInAs ou d'une superposition de plusieurs de ces alliages.

Dans un autre mode de réalisation, l'électrode 130 est réalisée dans un matériau III-V différent de celui utilisé pour réaliser la bande 33.

L'épaisseur e₃₂ peut être choisie différemment. Par exemple, en variante, les épaisseurs e₁₂ et e₃₂, respectivement, des extrémités proximales 12 et 32, sont choisies pour que le point où se situe le maximum d'intensité du champ optique du signal optique qui se propage dans le guide d'onde 70, soit le plus près possible de l'épaisseur de matériau diélectrique située à l'intérieur de la portion 20B. De préférence, ce point M est situé au centre de l'épaisseur e_{20B} de matériau diélectrique de la portion 20B. En effet, c'est au niveau des interfaces entre les extrémités proximales 12, 32 et le matériau diélectrique de la portion 20B que la densité de porteurs de charges est maximale lorsqu'une différence de potentiels est présente entre les extrémités proximales 11 et 31. Cela améliore donc l'efficacité du modulateur 100. Par exemple, à cette fin, dans le cas où les indices de réfraction des extrémités proximales 12 et 32 sont proches l'un de l'autre, les épaisseurs e₁₂ et e₃₂ sont choisies sensiblement égales. Par exemple, l'épaisseur e₁₂ est comprise entre 0,5e₃₂ et 1,5e₃₂, et, de préférence, entre 0,7e₃₂ et 1,3e₃₂.

### Variantes de la source laser:

En variante, la surépaisseur 222B est omise. Dans ce cas, l'épaisseur maximale du guide d'onde 220 est égale à l'épaisseur de la couche 43.

En variante, la surépaisseur 222B est réalisée en silicium amorphe et non pas en silicium monocristallin. Dans ce cas, la surépaisseur est déposée sur le silicium monocristallin, non pas par croissance épitaxiale mais par dépôt.

D'autres matériaux à gain III-V sont possibles pour réaliser la source laser 7. Par exemple, la couche 36 est formée de l'empilement suivant en allant du bas vers le haut :
- une sous-couche inférieure en GaAs dopée N,
- des sous-couches à boites quantiques en AIGaAs , ou des puits quantiques AIGaAs, et
- une sous-couche supérieure en GaAs dopée P.

Le guide d'onde 220 peut prendre une configuration dite « en bande » c'est-à-dire que les bras latéraux 223G et 223D sont omis ou tout autre configuration capable de guider un signal optique.

### Autres variantes du modulateur :

Le modulateur 100 peut aussi être un modulateur en anneau. A cet effet, le guide d'onde 70 se referme sur lui-même pour former un guide d'onde annulaire dans lequel la densité des porteurs de charge peut être modifiée en fonction de la différence de potentiels appliquée entre les prises 21 et 22. Typiquement, ce guide d'onde annulaire est raccordé à un guide d'onde dans lequel se propage le signal optique à moduler par un couplage évanescent. Le guide d'onde 70 peut aussi constituer uniquement une portion limitée du guide d'onde annulaire.

Dans un autre mode de réalisation, le modulateur est utilisé pour moduler l'intensité du signal optique qui le traverse. En effet, une modification de la densité des porteurs de charge dans le guide d'onde 70 modifie également l'intensité du signal optique qui le traverse.

D'autres matériaux diélectriques sont possibles pour le matériau 116 et la couche 20. Par exemple, il peut s'agir de nitrure de silicium, de nitrure d'Aluminium, d'un polymère électriquement isolant, de Al₂O₃. De plus, dans le cas de la couche 20, son indice de réfraction n'est pas nécessairement inférieur à celui du silicium.

Dans une autre variante, la couche 20 est totalement éliminée là où elle n'est pas indispensable au fonctionnement du transmetteur. Par exemple, elle est totalement éliminée en dehors des portions 20A et 20B.

Quel que soit le mode de réalisation, il est possible d'intervertir les régions dopées N et P.

En variante, une partie ou la totalité des prises de contact sont réalisées, non pas à travers le matériau 117, mais à travers le substrat 44. Dans ce cas, par rapport à ce qui a été représenté sur les figures précédentes, une ou plusieurs prises de contact électrique émergent sous le substrat.

Le substrat 44 peut être réalisé dans d'autre matériau que du silicium.

En variante, les guides d'ondes 70, 220 sont incurvés. Dans ce cas, la conformation des différents éléments optiquement couplés à ces guides d'onde est adaptée au rayon de courbure de ces guides d'onde.

### Variantes du procédé de fabrication :

L'étape 502 peut comporter d'autres opérations en plus des opérations de gravure pour structurer les parties de composants optiques dans la couche 43 en silicium monocristallin. Par exemple, elle peut en plus comporter des opérations de dopage localisé de la couche 43. Par exemple, ces opérations de dopage localisé peuvent être utilisées pour obtenir le niveau de dopage requis pour l'extrémité 11 de l'électrode 120. Dans ce cas, l'étape 534 doit être adaptée en conséquence.

En variante, l'électrode 130 et le guide d'onde 200 sont réalisés à partir d'un même empilement de matériau III-V collé sur la face supérieure de la couche 20. Cet empilement est ensuite structuré pour obtenir l'électrode 130 et le guide d'onde 200.

La couche isolante 20 peut être obtenue par des procédés de fabrication différents. Par exemple, lors de l'opération 528, la couche 2 est complètement retirée jusqu'à la couche 3 puis la sous-couche 530 est déposée sur la couche 3 mise à nue. Dans ce cas, éventuellement, le matériau diélectrique de la couche 20 peut être différent du matériau 116. Par exemple, il peut s'agir d'un matériau diélelectrique tel qu'un polymère électriquement isolant ou en Al₂O₃. Après le retrait complet de la couche 2, il est aussi possible de réaliser la couche 20 par oxydation de la surface de la couche 3.

L'opération 540 d'encapsulation de la partie 12B peut être réalisée différemment. Par exemple, avant le collage de l'électrode 130, la sous-couche 30 en matériau III-V est oxydée pour former, après le collage, l'épaisseur e_{20B} d'oxyde située au-dessus de la partie 12B de l'électrode 120.

Dans une autre variante, la deuxième gravure totale localisée est remplacée par une gravure uniforme de toute la surface de la couche 3 pour transformer les régions non-amincies en régions amincies et éliminer complètement les régions amincies.

### Chapitre III : Avantages des modes de réalisation décrits

L'épaisseur de matériau diélectrique supérieure à 40 nm dans la portion 20A permet d'obtenir un couplage adiabatique entre le guide d'onde 220 et le guide d'onde 200 au lieu d'un couplage évanescent. Un couplage adiabatique est plus simple à réaliser qu'un couplage évanescent. Avantageusement, dans le cas d'un couplage adiabatique, il n'est pas nécessaire de structurer des pointes dans le guide d'onde 200 en matériau III-V. A l'inverse, dans le cas d'un couplage évanescent, des pointes doivent être structurées dans le guide d'onde 200. Or, la structuration de pointes dans un guide d'onde en matériau III-V est une opération complexe à réaliser, en fonction de son épaisseur et des orientations cristallines. Ainsi, le fait que l'épaisseur de matériau diélectrique entre les guides d'onde 200 et 220 soit supérieure à 40 nm simplifie la fabrication du transmetteur. En particulier, à cause de cela, le transmetteur 5 est plus simple à fabriquer que celui décrit dans la demande EP3206079A1.

Le fait que l'épaisseur de matériau diélectrique entre les deux électrodes 120 et 130 soit inférieure à 35 nm permet la réalisation d'un modulateur capacitif hybride. Si l'épaisseur de matériau diélectrique entre les deux électrodes 120 et 130 était supérieure, seul un modulateur à électro-absorption ou EAM (« Electro-absorption Modulator ») serait réalisable. Or, les modulateurs capacitifs hybrides présentent une bande passante bien plus grande que les modulateurs à électro-absorption. Les modulateurs capacitifs hybrides sont également avantageux par rapport aux modulateurs capacitifs non-hybrides, dans lesquels l'électrode 130 est aussi réalisée en silicium. En effet, les modulateurs capacitifs hybrides permettent d'obtenir des changements de phase 10 fois à 100 fois plus efficaces qu'un modulateur capacitif non-hybride. Ainsi, les transmetteurs décrits présentent des performances égales ou meilleures à celles du transmetteur de la demande EP3206079A1.

Enfin, le fait que l'épaisseur de matériau diélectrique entre les guides d'onde 200 et 220 et entre les électrodes 120 et 130 soit différente, permet d'obtenir un transmetteur qui présente en même temps les différents avantages ci-dessus, c'est-à-dire d'être à la fois simple à fabriquer tout en intégrant sur un même substrat une source laser et un modulateur capacitif hybride et tout en présentant à la fois pour la source laser et pour le modulateur capacitif hybride des performances optimisées.

Les procédés de fabrication décrits ici permettent d'ajuster l'épaisseur du matériau diélectrique dans la portion 20A indépendamment de l'épaisseur de matériau diélectrique dans la portion 20B de la couche 20. Les procédés décrits permettent donc de fabriquer sur le même substrat à la fois une source laser à semi-conducteur et un modulateur capacitif hybride.

Les procédés de fabrication décrits ici présentent en particulier les avantages suivants :
- Ils permettent de contrôler précisément l'épaisseur de la couche 20 et d'obtenir une couche 20 particulièrement plane car elle est réalisée du côté de la couche 3 qui a le même niveau partout, ce qui simplifie le collage d'empilement en matériau III-V pour la réalisation de l'électrode 130 et du guide d'onde 200.
- Ils permettent de régler précisément l'épaisseur de l'électrode 120 indépendamment de l'épaisseur du guide d'onde 220 et, plus généralement, indépendamment de l'épaisseur de la couche 43 en silicium monocristallin. Ceci est particulièrement utile car, généralement, pour améliorer le fonctionnement de la source laser 7, il faut que l'épaisseur du guide d'onde 220 soit assez grande, c'est-à-dire ici de l'ordre de 500 nm. A l'inverse, pour améliorer le fonctionnement du modulateur 100, comme expliqué ci-dessus, l'épaisseur de l'électrode 120 et, en particulier de son extrémité proximale 12, est généralement inférieure à l'épaisseur e₂₂₂.
- Ce procédé permet d'éviter la formation d'une capacité parasite sous l'extrémité distale 31 et donc un fonctionnement plus rapide du modulateur 100.

## Revendications

1. Transmetteur photonique comportant :
- un empilement comportant un substrat (44) s'étendant principalement dans un plan appelé « plan du substrat » et les couches suivantes empilées successivement les unes au-dessus des autres et s'étendant chacune principalement parallèlement au plan du substrat :
• une première couche (3) située directement sur le substrat et comportant du silicium monocristallin encapsulé dans un matériau diélectrique (116),
• une deuxième couche (20) située directement sur la première couche (3) et comportant un matériau diélectrique,
• une troisième couche (36) située directement sur la deuxième couche (20) et comportant un matériau à gain III-V et un matériau cristallin III-V dopé encapsulés dans un matériau diélectrique (117),
- une source laser (7) à semi-conducteur apte à générer un signal optique, cette source laser comportant :
• un premier guide d'onde (220) en silicium structuré dans le silicium monocristallin de la première couche (3), et
• un deuxième guide d'onde (200) en matériau à gain III-V structuré dans le matériau à gain III-V de la troisième couche (36), les premier et deuxième guides d'onde étant couplés optiquement l'un à l'autre par un couplage adiabatique et étant séparés l'un de l'autre à cet effet par une première portion (20A) de la deuxième couche (20), à l'intérieur de cette première portion (20A) de la deuxième couche (20), l'épaisseur du matériau diélectrique étant égale à l'épaisseur de la deuxième couche,
- un modulateur (100) de phase réalisé sur le même substrat (44) et apte à moduler le signal optique généré par la source laser à semi-conducteur, ce modulateur comportant :
• une première électrode (120) en silicium monocristallin dopé P ou N dont une première partie (12A) est structurée dans le silicium monocristallin de la première couche (3),
• une seconde électrode (130) en matériau cristallin III-V dopé structurée dans le matériau cristallin III-V dopé de la troisième couche, cette seconde électrode présentant un dopage de signe opposé à celui de la première électrode et étant séparée de la première électrode par une deuxième portion (20B) de la deuxième couche (20),
**caractérisé en ce que** :
- l'épaisseur de la deuxième couche (20) est comprise entre 40 nm et 1 µm, et
- à l'intérieur de la deuxième portion (20B) de la deuxième couche (20), l'épaisseur du matériau diélectrique est comprise entre 5 nm et 35 nm, le reste de l'épaisseur de la deuxième couche à l'intérieur de la deuxième portion (20B) étant formé par une épaisseur en matériau semi-conducteur directement située sur la première partie (12A) de la première électrode et qui forme ainsi une deuxième partie (12B) de la première électrode, l'épaisseur en matériau semi-conducteur étant choisie dans le groupe constitué d'une épaisseur de silicium, d'une épaisseur d'un alliage SiGe et d'une superposition d'épaisseurs en silicium et en alliage SiGe.

2. Transmetteur photonique selon la revendication 1, dans lequel :
- le matériau cristallin III-V dopé de la troisième couche (36) s'étend directement sur la deuxième couche (20),
- la première électrode (120) du modulateur s'étend, dans une direction transversale (X) parallèle au plan du substrat, depuis une extrémité proximale (12) jusqu'à une extrémité distale (11), et s'étendant longitudinalement dans la direction (Y) de propagation du signal optique,
- la seconde électrode (130) du modulateur s'étendant, dans la direction transversale (X), depuis une extrémité proximale (32) située en vis-à-vis de l'extrémité proximale (12) de la première électrode (120) jusqu'à une extrémité distale (31) située d'un côté opposé à l'extrémité distale (11) de la première électrode (120) par rapport à un plan perpendiculaire au plan du substrat et traversant les extrémités proximales (12, 32), cette seconde électrode (130) s'étendant longitudinalement également dans la direction (Y) de propagation du signal optique,
- le modulateur (100) comporte également des prises de contact (21, 22) directement en contact mécanique et électrique avec, respectivement, les extrémités distales (11, 31) des électrodes (120, 130) pour raccorder électriquement les première et seconde électrodes à des potentiels électriques différents de manière à modifier la densité de porteurs de charges à l'intérieur d'un troisième guide d'onde (70) formé par la superposition des extrémités proximales (12, 32) des électrodes et la deuxième portion (20B) de la deuxième couche (20) interposée entre ces extrémités proximales (12).

3. Transmetteur selon la revendication 2, dans lequel l'épaisseur maximale de l'extrémité proximale (12) de la première électrode (120) est strictement inférieure à l'épaisseur maximale du premier guide d'onde (220).

4. Transmetteur selon la revendication 2 ou 3, dans lequel l'épaisseur maximale de l'extrémité proximale (12) de la première électrode (120) est comprise entre 0,7e₃₂ et 1,3e₃₂, où e₃₂ est l'épaisseur maximale de l'extrémité proximale (32) de la seconde électrode (130).

5. Transmetteur selon l'une quelconque des revendications précédentes, dans lequel la seconde électrode (130) est réalisée dans un matériau III-V choisi dans le groupe constitué de l'alliage InP, de l'alliage AsGa, de l'alliage InGaAsP ou par une superposition de plusieurs des alliages de groupe.

6. Transmetteur selon l'une quelconque des revendications 2 à 5, dans lequel le modulateur comporte une zone (34) uniquement composée d'un ou plusieurs matériaux diélectriques solides (116) qui s'étend :
- dans la direction perpendiculaire au plan du substrat, depuis l'extrémité distale (31) de la seconde électrode jusqu'au substrat (44), et
- dans la direction transversale (X) et dans la direction (Y) de propagation du signal optique, sous la totalité de l'extrémité distale (31) de la seconde électrode (130).

7. Transmetteur selon l'une quelconque des revendications précédentes, dans lequel la seconde électrode (130) s'étendant directement sur la deuxième couche (20).

8. Procédé de fabrication d'un transmetteur photonique à semi-conducteur conforme à l'une quelconque des revendications précédentes, ce procédé comportant :
- la réalisation (502, 527, 541) d'un empilement comportant un substrat (44) s'étendant principalement dans un plan appelé « plan du substrat » et les couches suivantes empilées successivement les unes au-dessus des autres et s'étendant chacune principalement parallèlement au plan du substrat :
• une première couche (3) située directement sur le substrat comportant du silicium monocristallin encapsulé dans un matériau diélectrique (116),
• une deuxième couche (20) située directement sur la première couche (3) et comportant un matériau diélectrique,
• une troisième couche (36) située directement sur la deuxième couche (20) et comportant un matériau à gain III-V et un matériau cristallin III-V dopé encapsulés dans un matériau diélectrique (117),
- la réalisation (502, 527, 541) d'une source laser (7) à semi-conducteur apte à générer un signal optique, cette source laser comportant :
• un premier guide d'onde (220) en silicium structuré dans le silicium monocristallin de la première couche (3), et
• un deuxième guide d'onde (200) en matériau à gain III-V structuré dans le matériau à gain III-V de la troisième couche (36), les premier et deuxième guides d'onde étant couplés optiquement l'un à l'autre par un couplage adiabatique et étant séparés l'un de l'autre à cet effet par une première portion (20A) de la deuxième couche (20), à l'intérieur de cette première portion (20A) de la deuxième couche (20), l'épaisseur du matériau diélectrique étant égale à l'épaisseur de la deuxième couche,
- la réalisation (502, 527, 541) d'un modulateur (100) de phase réalisé sur le même substrat (44) et apte à moduler le signal optique généré par la source laser à semi-conducteur, ce modulateur comportant :
• une première électrode (120) en silicium monocristallin dopé P ou N dont une première partie (12A) est structurée dans le silicium monocristallin de la première couche (3),
• une seconde électrode (130) en matériau cristallin III-V dopé structurée dans le matériau cristallin III-V dopé de la troisième couche, cette seconde électrode présentant un dopage de signe opposé à celui de la première électrode et étant séparée de la première électrode par une deuxième portion (20B) de la deuxième couche (20),
**caractérisé en ce que**, la réalisation de l'empilement comporte la réalisation (527) de la deuxième couche (20) avec les caractéristiques suivantes :
- l'épaisseur de la deuxième couche (20) est comprise entre 40 nm et 1 µm, et
- à l'intérieur de la deuxième portion (20B) de la deuxième couche (20), l'épaisseur du matériau diélectrique est comprise entre 5 nm et 35 nm, le reste de l'épaisseur de la deuxième couche à l'intérieur de la deuxième portion étant formé par une épaisseur en matériau semi-conducteur directement située sur la première partie de la première électrode et qui forme ainsi une deuxième partie (12B) de la première électrode, l'épaisseur en matériau semi-conducteur étant choisie dans le groupe constitué d'une épaisseur de silicium, d'une épaisseur d'un alliage SiGe et d'une superposition d'épaisseurs en silicium et en alliage SiGe.

9. Procédé selon la revendication 8, dans lequel la réalisation (527) de la deuxième couche comporte :
- la formation (528 ; 702) sur le silicium monocristallin de la première couche, d'une première sous-couche en matériau diélectrique d'épaisseur égale à l'épaisseur souhaitée pour la deuxième partie (12B) de la première électrode, puis
- à l'emplacement de la deuxième portion de la deuxième couche, la réalisation (532) dans la première sous-couche d'une tranchée dont le fond débouche sur le silicium monocristallin de la première couche, et l'absence de réalisation d'une telle tranchée à l'emplacement de la première portion de la deuxième couche, puis
- le remplissage (532) de la tranchée avec du matériau semi-conducteur pour former la deuxième partie (12B) de la première électrode dont l'épaisseur est égale à l'épaisseur de la première sous-couche, puis
- l'encapsulation (540 ; 706) dans une deuxième sous-couche en matériau diélectrique de la deuxième partie (12B) formée, l'épaisseur de cette deuxième sous-couche étant égale à l'épaisseur du matériau diélectrique à l'intérieur de la deuxième portion.

10. Procédé selon la revendication 8 ou 9, dans lequel la réalisation du premier guide d'onde (220) de la source laser comporte :
- la gravure (514, 516) d'une couche (43) de silicium monocristallin pour délimiter dans cette couche de silicium monocristallin une partie centrale (222A) du premier guide d'onde, puis
- la formation (520), sur cette partie centrale du premier guide d'onde, d'une surépaisseur (222B) en silicium pour augmenter localement l'épaisseur du premier guide d'onde.

## Patentansprüche

1. Photonensender, aufweisend:
- einen Stapel, der ein Substrat (44), das sich im Wesentlichen in einer als "Substratebene" bezeichneten Ebene erstreckt, und die folgenden nacheinander übereinander gestapelten Schichten aufweist, die sich jeweils im Wesentlichen parallel zur Substratebene erstrecken:
• eine erste Schicht (3), die unmittelbar auf dem Substrat liegt und einkristallines Silicium aufweist, das in einem dielektrischen Material (116) eingekapselt ist,
• eine zweite Schicht (20), die unmittelbar auf der ersten Schicht (3) liegt und ein dielektrisches Material aufweist,
• eine dritte Schicht (36), die unmittelbar auf der zweiten Schicht (20) liegt und ein III-V-Gain-Material und ein dotiertes kristallines III-V-Material aufweist, die in einem dielektrischen Material (117) eingekapselt sind,
- eine Halbleiterlaserquelle (7), die in der Lage ist, ein optisches Signal zu erzeugen, wobei diese Laserquelle Folgendes aufweist:
• einen ersten Wellenleiter (220) aus Silicium, der als Struktur in dem einkristallinen Silicium der ersten Schicht (3) vorgesehen ist, und
• einen zweiten Wellenleiter (200) aus einem III-V-Gain-Material, der als Struktur in dem III-V-Gain-Material der dritten Schicht (36) vorgesehen ist, wobei der erste und zweite Wellenleiter über eine adiabate Verbindung optisch miteinander verbunden und dazu über einen ersten Abschnitt (20A) der zweiten Schicht (20) voneinander getrennt sind, wobei die Dicke des dielektrischen Materials im Inneren dieses ersten Abschnitts (20A) der zweiten Schicht (20) der Dicke der zweiten Schicht entspricht,
- einen Phasenmodulator (100), der auf demselben Substrat (44) ausgeführt ist und in der Lage ist, das von der Halbleiterlaserquelle erzeugte optische Signal zu modulieren, wobei dieser Modulator Folgendes aufweist:
• eine erste Elektrode (120) aus p- oder n-dotiertem einkristallinem Silicium, von der ein erster Teil (12A) als Struktur im einkristallinem Silicium der ersten Schicht (3) vorgesehen ist,
• eine zweite Elektrode (130) aus dotiertem kristallinem III-V-Material, die als Struktur in dem dotierten kristallinen III-V-Material der dritten Schicht vorgesehen ist, wobei diese zweite Elektrode eine Dotierung vom umgekehrten Typ zu dem der ersten Elektrode aufweist und von der ersten Elektrode durch einen zweiten Abschnitt (20B) der zweiten Schicht (20) getrennt ist,
**dadurch gekennzeichnet, dass**:
- die Dicke der zweiten Schicht (20) zwischen 40 nm und 1 µm beträgt, und
- die Dicke des dielektrischen Materials im Inneren des zweiten Abschnitts (20B) der zweiten Schicht (20) zwischen 5 nm und 35 nm beträgt, wobei die übrige Dicke der zweiten Schicht im Inneren des zweiten Abschnitts (20B) von einer Dicke aus einem Halbleitermaterial gebildet ist, die unmittelbar auf dem ersten Teil (12A) der ersten Elektrode liegt und so einen zweiten Teil (12B) der ersten Elektrode bildet, wobei die Dicke aus einem Halbleitermaterial aus der Gruppe ausgewählt ist, die aus einer Dicke aus Silicium, einer Dicke aus einer SiGe-Legierung und übereinander angeordneten Dicken aus Silicium und aus einer SiGe-Legierung besteht.

2. Photonensender nach Anspruch 1, wobei:
- sich das dotierte kristalline III-V-Material der dritten Schicht (36) unmittelbar auf der zweiten Schicht (20) erstreckt,
- sich die erste Elektrode (120) des Modulators von einem proximalen Ende (12) bis zu einem distalen Ende (11) in einer Querrichtung (X) parallel zur Substratebene erstreckt und sich längs in der Richtung (Y) der Ausbreitung des optischen Signals erstreckt,
- sich die zweite Elektrode (130) des Modulators in der Querrichtung (X) von einem proximalen Ende (32), das dem proximalen Ende (12) der ersten Elektrode (120) gegenüberliegt, bis zu einem distalen Ende (31) erstreckt, das bezogen auf eine Ebene, die senkrecht zur Substratebene und durch die proximalen Enden (12, 32) verläuft, auf einer dem distalen Ende (11) der ersten Elektrode (120) gegenüberliegenden Seite liegt, wobei sich diese zweite Elektrode (130) längs ebenfalls in der Richtung (Y) der Ausbreitung des optischen Signals erstreckt,
- der Modulator (100) auch Anschlusskontakte (21, 22) aufweist, die unmittelbaren mechanischen und elektrischen Kontakt jeweils zu den distalen Enden (11, 31) der Elektroden (120, 130) haben und so die erste und zweite Elektrode elektrisch mit unterschiedlichen elektrischen Potentialen verbinden, damit die Ladungsträgerdichte im Inneren eines dritten Wellenleiters (70) modifiziert wird, der durch das übereinander erfolgende Anordnen der proximalen Enden (12, 32) der Elektroden und den zweiten Abschnitt (20B) der zweiten Schicht (20) gebildet wird, die zwischen diesen proximalen Enden (12) angeordnet ist.

3. Sender nach Anspruch 2, wobei die Höchstdicke des proximalen Endes (12) der ersten Elektrode (120) grundsätzlich kleiner als die Höchstdicke des ersten Wellenleiters (220) ist.

4. Sender nach Anspruch 2 oder 3, wobei die Höchstdicke des proximalen Endes (12) der ersten Elektrode (120) zwischen 0,7e32 und 1,3e₃₂ liegt, wobei e₃₂ die Höchstdicke des proximalen Endes (32) der zweiten Elektrode (130) ist.

5. Sender nach einem der vorhergehenden Ansprüche, wobei die zweite Elektrode (130) aus einem III-V-Material hergestellt ist, das aus der Gruppe ausgewählt ist, die aus der Legierung InP, der Legierung AsGa, der Legierung InGaAsP besteht, oder durch übereinander erfolgendes Anordnen von mehreren der Legierungen aus der Gruppe hergestellt ist.

6. Sender nach einem der Ansprüche 2 bis 5, wobei der Modulator einen Bereich (34) aufweist, der ausschließlich aus einem oder mehreren dielektrischen Feststoffen (116) aufgebaut ist und sich folgendermaßen erstreckt:
- in der Richtung senkrecht zur Substratebene vom distalen Ende (31) der zweiten Elektrode aus bis zum Substrat (44), und
- in der Querrichtung (X) und in der Richtung (Y) der Ausbreitung des optischen Signals unter dem gesamten distalen Ende (31) der zweiten Elektrode (130).

7. Sender nach einem der vorhergehenden Ansprüche, wobei sich die zweite Elektrode (130) unmittelbar auf der zweiten Schicht (20) erstreckt.

8. Verfahren zur Herstellung eines Halbleiter-Photonensenders nach einem der vorhergehenden Ansprüche, wobei dieses Verfahren umfasst:
- Herstellen (502, 527, 541) eines Stapels, der ein Substrat (44), das sich im Wesentlichen in einer als "Substratebene" bezeichneten Ebene erstreckt, und die folgenden nacheinander übereinander gestapelten Schichten aufweist, die sich jeweils im Wesentlichen parallel zur Substratebene erstrecken:
• eine erste Schicht (3), die unmittelbar auf dem Substrat liegt und einkristallines Silicium aufweist, das in einem dielektrischen Material (116) eingekapselt ist,
• eine zweite Schicht (20), die unmittelbar auf der ersten Schicht (3) liegt und ein dielektrisches Material aufweist,
• eine dritte Schicht (36), die unmittelbar auf der zweiten Schicht (20) liegt und ein III-V-Gain-Material und ein dotiertes kristallines III-V-Material aufweist, die in einem dielektrischen Material (117) eingekapselt sind,
- Herstellen (502, 527, 541) einer Halbleiterlaserquelle (7), die in der Lage ist, ein optisches Signal zu erzeugen, wobei diese Laserquelle Folgendes aufweist:
• einen ersten Wellenleiter (220) aus Silicium, der als Struktur in dem einkristallinen Silicium der ersten Schicht (3) vorgesehen ist, und
• einen zweiten Wellenleiter (200) aus einem III-V-Gain-Material, der als Struktur in dem III-V-Gain-Material der dritten Schicht (36) vorgesehen ist, wobei der erste und zweite Wellenleiter über eine adiabate Verbindung optisch miteinander verbunden und dazu über einen ersten Abschnitt (20A) der zweiten Schicht (20) voneinander getrennt sind, wobei die Dicke des dielektrischen Materials im Inneren dieses ersten Abschnitts (20A) der zweiten Schicht (20) der Dicke der zweiten Schicht entspricht,
- Herstellen (502, 527, 541) eines Phasenmodulators (100), der auf demselben Substrat (44) ausgeführt ist und in der Lage ist, das von der Halbleiterlaserquelle erzeugte optische Signal zu modulieren, wobei dieser Modulator Folgendes aufweist:
• eine erste Elektrode (120) aus p- oder n-dotiertem einkristallinem Silicium, von der ein erster Teil (12A) als Struktur im einkristallinem Silicium der ersten Schicht (3) vorgesehen ist,
• eine zweite Elektrode (130) aus dotiertem kristallinem III-V-Material, die als Struktur in dem dotierten kristallinen III-V-Material der dritten Schicht vorgesehen ist, wobei diese zweite Elektrode eine Dotierung vom umgekehrten Typ zu dem der ersten Elektrode aufweist und von der ersten Elektrode durch einen zweiten Abschnitt (20B) der zweiten Schicht (20) getrennt ist,
**dadurch gekennzeichnet, dass** das Herstellen des Stapels das Herstellen (527) der zweiten Schicht (20) mit folgenden Eigenschaften umfasst:
- die Dicke der zweiten Schicht (20) beträgt zwischen 40 nm und 1 µm, und
- im Inneren des zweiten Abschnitts (20B) der zweiten Schicht (20) beträgt die Dicke des dielektrischen Materials zwischen 5 nm und 35 nm, wobei die übrige Dicke der zweiten Schicht im Inneren des zweiten Abschnitts von einer Dicke aus einem Halbleitermaterial gebildet ist, die unmittelbar auf dem ersten Teil der ersten Elektrode liegt und so einen zweiten Teil (12B) der ersten Elektrode bildet, wobei die Dicke aus einem Halbleitermaterial aus der Gruppe ausgewählt ist, die aus einer Dicke aus Silicium, einer Dicke aus einer SiGe-Legierung und übereinander angeordneten Dicken aus Silicium und aus einer SiGe-Legierung besteht.

9. Verfahren nach Anspruch 8, wobei das Herstellen (527) der zweiten Schicht umfasst:
- das Bilden (528; 702), auf dem einkristallinen Silicium der ersten Schicht, einer ersten Teilschicht aus einem dielektrischen Material mit einer Dicke, die der gewünschten Dicke für den zweiten Teil (12B) der ersten Elektrode entspricht, dann
- an der Stelle des zweiten Abschnitts der zweiten Schicht Herstellen (532) eines Grabens in der ersten Teilschicht, dessen Boden zum einkristallinen Silicium der ersten Schicht hin führt, und nicht erfolgendes Herstellen eines derartigen Grabens an der Stelle des ersten Abschnitts der zweiten Schicht, dann
- Auffüllen (532) des Grabens mit Halbleitermaterial zum Bilden des zweiten Teils (12B) der ersten Elektrode, dessen Dicke der Dicke der ersten Teilschicht entspricht, dann
- Einkapseln (540; 706), in einer zweiten Teilschicht aus dielektrischem Material, des gebildeten zweiten Teils (12B), wobei die Dicke dieser zweiten Teilschicht der Dicke des dielektrischen Materials im Inneren des zweiten Abschnitts entspricht.

10. Verfahren nach Anspruch 8 oder 9, wobei das Herstellen des ersten Wellenleiters (220) der Laserquelle umfasst:
- Ätzen (514, 516) einer Schicht (43) aus einkristallinem Silicium zum Abgrenzen, in dieser Schicht aus einkristallinem Silicium, eines mittigen Teils (222A) des ersten Wellenleiters, dann
- Bilden (520), auf diesem mittigen Teil des ersten Wellenleiters, einer Dickenüberhöhung (222B) aus Silicium zum lokalen Vergrößern der Dicke des ersten Wellenleiters.

## Claims

1. Photonic transmitter comprising:
- a stack comprising a substrate (44) mainly lying in a plane called the "plane of the substrate" and the following layers successively stacked one on top of the other and each mainly lying parallel to the plane of the substrate:
• a first layer (3) located directly on the substrate and comprising single-crystal silicon encapsulated in a dielectric material (116),
• a second layer (20) located directly on the first layer (3) and comprising a dielectric material,
• a third layer (36) located directly on the second layer (20) and comprising a III-V gain material and a doped III-V crystalline material, which materials are encapsulated in a dielectric material (117),
- a semiconductor laser source (7) able to generate an optical signal, this laser source comprising:
• a first waveguide (220) made of silicon structured in the single-crystal silicon of the first layer (3), and
• a second waveguide (200) made of III-V gain material structured in the III-V gain material of the third layer (36), the first and second waveguides being optically coupled to each other by adiabatic coupling and being separated from each other to this end by a first segment (20A) of the second layer (20), in the interior of this first segment (20A) of the second layer (20), the thickness of the dielectric material being equal to the thickness of the second layer,
- a phase modulator (100) produced on the same substrate (44) and able to modulate the optical signal generated by the semiconductor laser source, this modulator comprising:
• a first electrode (120) made of n- or p-doped single-crystal silicon a first portion (12A) of which is structured in the single-crystal silicon of the first layer (3),
• a second electrode (130) made of doped III-V crystalline material structured in the doped III-V crystalline material of the third layer, the doping of this second electrode being of opposite type to that of the first electrode, said second electrode being separated from the first electrode by a second segment (20B) of the second layer (20),
**characterized in that**:
- the thickness of the second layer (20) is comprised between 40 nm and 1 µm, and
- in the interior of the second segment (20B) of the second layer (20), the thickness of the dielectric material is comprised between 5 nm and 35 nm, the rest of the thickness of the second layer in the interior of the second segment (20B) being formed by a thickness of semiconductor material directly located on the first portion (12A) of the first electrode and that thus forms a second portion (12B) of the first electrode, the thickness of semiconductor material being chosen from the group consisting of a thickness of silicon, a thickness of an SiGe alloy and a superposition of thicknesses made of silicon and made of SiGe alloy.

2. Photonic transmitter according to Claim 1, wherein:
- the doped III-V crystalline material of the third layer (36) lies directly on the second layer (20),
- the first electrode (120) of the modulator extends, in a transverse direction (X) parallel to the plane of the substrate, from a near end (12) to a far end (11), and extends longitudinally in the propagation direction (Y) of the optical signal,
- the second electrode (130) of the modulator extends, in the transverse direction (X), from a near end (32) located facing the near end (12) of the first electrode (120) to a far end (31) located on a side opposite to the far end (11) of the first electrode (120) with respect to a plane perpendicular to the plane of the substrate and passing through the near ends (12, 32), this second electrode (130) also extending longitudinally in the propagation direction (Y) of the optical signal,
- the modulator (100) also comprises contacts (21, 22) making direct mechanical and electrical contact with, respectively, the far ends (11, 31) of the electrodes (120, 130) in order to electrically connect the first and second electrodes to different electrical potentials so as to modify the charge carrier density in the interior of a third waveguide (70) formed by the superposition of the near ends (12, 32) of the electrodes and the second segment (20B) of the second layer (20) interposed between these near ends (12).

3. Transmitter according to Claim 2, wherein the maximum thickness of the near end (12) of the first electrode (120) is strictly smaller than the maximum thickness of the first waveguide (220).

4. Transmitter according to Claim 2 or 3, wherein the maximum thickness of the near end (12) of the first electrode (120) is comprised between 0.7e32 and 1.3e32, where e₃₂ is the maximum thickness of the near end (32) of the second electrode (130).

5. Transmitter according to any one of the preceding claims, wherein the second electrode (130) is made from a III-V material chosen from the group consisting of the alloy InP, the alloy GaAs, the alloy InGaAsP or a superposition of a plurality of alloys of this group.

6. Transmitter according to any one of Claims 2 to 5, wherein the modulator comprises a zone (34) solely composed of one or more solid dielectric materials (116) that extends:
- in the direction perpendicular to the plane of the substrate, from the far end (31) of the second electrode to the substrate (44), and
- in the transverse direction (X) and in the propagation direction (Y) of the optical signal, under the entirety of the far end (31) of the second electrode (130).

7. Transmitter according to any one of the preceding claims, wherein the second electrode (130) lies directly on the second layer (20).

8. Process for fabricating a semiconductor photonic transmitter according to any one of the preceding claims, this process comprising:
- producing (502, 527, 541) a stack comprising a substrate (44) mainly lying in a plane called the "plane of the substrate" and the following layers successively stacked one on top of the other and each mainly lying parallel to the plane of the substrate:
• a first layer (3) located directly on the substrate comprising single-crystal silicon encapsulated in a dielectric material (116),
• a second layer (20) located directly on the first layer (3) and comprising a dielectric material,
• a third layer (36) located directly on the second layer (20) and comprising a III-V gain material and a doped III-V crystalline material, which materials are encapsulated in a dielectric material (117),
- producing (502, 527, 541) a semiconductor laser source (7) able to generate an optical signal, this laser source comprising:
• a first waveguide (220) made of silicon structured in the single-crystal silicon of the first layer (3), and
• a second waveguide (200) made of III-V gain material structured in the III-V gain material of the third layer (36), the first and second waveguides being optically coupled to each other by adiabatic coupling and being separated from each other to this end by a first segment (20A) of the second layer (20), in the interior of this first segment (20A) of the second layer (20), the thickness of the dielectric material being equal to the thickness of the second layer,
- producing (502, 527, 541) a phase modulator (100) produced on the same substrate (44) and able to modulate the optical signal generated by the semiconductor laser source, this modulator comprising:
• a first electrode (120) made of n- or p-doped single-crystal silicon a first portion (12A) of which is structured in the single-crystal silicon of the first layer (3),
• a second electrode (130) made of doped III-V crystalline material structured in the doped III-V crystalline material of the third layer, the doping of this second electrode being of opposite type to that of the first electrode, said second electrode being separated from the first electrode by a second segment (20B) of the second layer (20),
**characterized in that** producing the stack comprises producing (527) the second layer (20) with the following features:
- the thickness of the second layer (20) is comprised between 40 nm and 1 µm, and
- in the interior of the second segment (20B) of the second layer (20), the thickness of the dielectric material is comprised between 5 nm and 35 nm, the rest of the thickness of the second layer in the interior of the second segment being formed by a thickness of semiconductor material directly located on the first portion of the first electrode and that thus forms a second portion (12B) of the first electrode, the thickness of semiconductor material being chosen from the group consisting of a thickness of silicon, a thickness of an SiGe alloy and a superposition of thicknesses made of silicon and made of SiGe alloy.

9. Process according to Claim 8, wherein producing (527) the second layer comprises:
- forming (528; 702), on the single-crystal silicon of the first layer, a first sublayer made of dielectric material of thickness equal to the thickness desired for the second portion (12B) of the first electrode, then
- in the location of the second segment of the second layer, producing (532), in the first sublayer, a trench the bottom of which opens onto the single-crystal silicon of the first layer, and not producing such a trench in the location of the first segment of the second layer, then
- filling (532) the trench with the semiconductor material in order to form the second portion (12B) of the first electrode the thickness of which is equal to the thickness of the first sublayer, then
- encapsulating (540; 706), in a second sublayer made of dielectric material, the formed second portion (12B), the thickness of this second sublayer being equal to the thickness of the dielectric material in the interior of the second segment.

10. Process according to Claim 8 or 9, wherein producing the first waveguide (220) of the laser source comprises:
- etching (514, 516) a layer (43) of single-crystal silicon in order to delineate, in this layer of single-crystal silicon, a central portion (222A) of the first waveguide, then
- forming (520), on this central portion of the first waveguide, an additional thickness (222B) of silicon in order to locally increase the thickness of the first waveguide.
